(19) Europäisches Patentamt
European Patent Office
Office européen des brevets

(11) EP 3 396 152 A1

(12) EUROPEAN PATENT APPLICATION

(43) Date of publication:
31.10.2018 Bulletin 2018/44

(51) Int Cl.:
F02N 11/08 (2006.01)　　H02J 7/34 (2006.01)
H02J 1/06 (2006.01)　　B60R 16/033 (2006.01)
H02J 1/00 (2006.01)

(21) Application number: 18169374.8

(22) Date of filing: 25.04.2018

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 26.04.2017　TW 106114002
12.01.2018　TW 107101140

(71) Applicant: Team Young Technology Co., Ltd.
32070 Taoyuan City (TW)

(72) Inventors:
• LIN, Tz-Min
334 Taoyuan City (TW)
• WANG, Cheng-Chung
334 Taoyuan City (TW)

(74) Representative: Emde, Eric
Wagner & Geyer
Gewürzmühlstrasse 5
80538 München (DE)

(54) BATTERY POWER SUSTAINABILITY DEVICE AND METHOD FOR BATTERY POWER SUSTAINABILITY

(57) A battery power sustainability device (10) includes a switch device (15) and a processing circuit (11). The processing circuit controls the switch device to establish a parallel connection between a rapid energy storage module (13) and a battery (33) in a start-up mode and disconnect the parallel connection between the rapid energy storage module and the battery after entering a charging mode. When a battery-powered system stops operating, the battery-powered system charges the rapid energy storage module. When the battery-powered system starts up, the drawn power of the battery is decreased under the help of the rapid energy storage module that has enough power. Thus, the using life of the battery is extended and can achieve a normal start-up function even the battery has lower power and thereby the power of the battery can be used until exhausted completely. By means of detecting the battery performance, users can safely use up all available battery power.

FIG. 1

**Description**

BACKGROUND OF THE INVENTION

Field of the Invention

The invention relates to a battery-powered system, and more particularly, to a battery power sustainability device and a method for battery power sustainability.

Description of Related Art

Currently, in case a vehicle is at a status of low voltage (start-up battery deads), the vehicle cannot be started by an original start-up system, and therefore the start-up system requires a jump start. A jump start includes parallelly connecting another battery at two electrode ends of the battery of the start-up system such that the start-up system has sufficient voltage value to be triggered.

The way of jump start is not only tedious, but also dangerous in case of a misconnection of the electrodes of the battery.

Moreover, any electronic device requiring the battery in the vehicle reduces the voltage of the battery at an instant of start-up. Therefore, how to stabilize the voltage of the battery to extend the using life of the electronic device and the ignition system, and how to increase battery life are urged to be resolved.

To solve the issues above, CN103812166 discloses a vehicle start-up power source in which a battery is serially connected to a switch first and then parallelly connected with a supercapacitor. The switch is open when the remaining battery power is less than a pre-set value and is closed to make the battery charge the supercapacitor to achieve a secondary start-up when a vehicle start-up signal is received. However, in such a vehicle start-up power source, since the connection between the battery and the system and the parallel connection between the battery and the capacitor are cut off by the controlled switch when the battery power is under a low power so as to retain remaining battery power, and the controlled switch is closed when a secondary start-up signal is generated so as to make the battery charges the supercapacitor using the remaining power, the battery will bear a load of simultaneously performing the start-up and charging the supercapacitor, which results in an exacerbation of drawing power and an accelerated aging. Thus, there is exactly an issue of failing to simultaneously start-up the vehicle and charge the supercapacitor with sufficient.

SUMMARY OF THE INVENTION

Due to the above drawbacks, an object of the invention is to provide a battery power sustainability device and method such that a battery-powered system can achieve a start-up purpose powered by the battery with an assistance of the battery power sustainability device and an effect of stabilizing the voltage of the start-up battery during a normal operation of the system by means of the battery power sustainability device, thereby extending the using life of the start-up battery and electronic devices in the vehicle.

Another object of the invention is to provide a battery power sustainability device that can reduce battery peak load, extend battery life, and accurately detect battery life state so as to get a purpose of exhausting the battery power. As a result, the user can replace the battery just before the battery is exhausted without any worry, and a battery resource waste and environmental pollution caused by replacing the battery too early can be reduced.

To achieve the above objects, the battery power sustainability device of the invention is applied in a battery-powered system and includes a switch device and a processing circuit. The switch device controls a connection between a rapid energy storage module and a start-up battery. The processing circuit is configured to control a status of the switch device in response to a plurality of operating modes, including controlling the switch device to establish a parallel connection between the rapid energy storage module and the start-up battery in a start-up mode. Moreover, the switch device is controlled to disconnect the parallel connection between the rapid energy storage module and the start-up battery in a charging mode started by receiving a trigger signal, and wherein the trigger signal is generated by an operation stop signal of the battery-powered system.

To achieve the above objects, the invention further provides a method for battery power sustainability, including a parallel connection step and a charging step. The parallel connection step is configured to control a switch device to establish a parallel connection between the rapid energy storage module and the start-up battery in the start-up mode. The charging step is configured to control the switch device to disconnect the parallel connection between the rapid energy storage module and the start-up battery in a charging mode started by receiving a trigger signal, and can charge the rapid energy storage module via the processing circuit by using the start-up battery as a power source to a voltage over a bootable voltage value. In particular, the trigger signal is generated according to an operation stop signal of the battery-powered system. In another viewpoint, after parallel connection between the battery and the rapid energy storage module is established via the trigger signal, the rapid energy storage module can be immediately charged by the battery to a voltage over a bootable voltage, and can also be charged only when the voltage of the rapid energy storage module is less than a designated voltage value.

Moreover, to achieve another object of the invention, the battery power sustainability device disclosed in the invention further includes a measuring circuit configured to detect and compare various electrical drawn properties of the battery in a number of times of start-up, and generate a replacement warning when the battery meets a low drawn power condition.

By means of the device and method above, when the system stops operating, the trigger signal can make the processing circuit disconnect the parallel connection between the start-up battery and the rapid energy storage module and can make the battery charge the rapid energy storage module to a voltage over a bootable voltage. A parallel connection between the battery and the rapid energy storage module are parallel connected again at a start-up stage such that the battery-powered system can be started with the assistance of the power of the rapid energy storage module. Therefore, at a next start-up, the battery does not need to charge the rapid energy storage module simultaneously as in the prior art, and instead instantly uses the rapid energy storage module having sufficient power as an auxiliary for starting the battery-powered system so as to reduce instant exacerbated load for the battery and ensure the rapid energy storage module successfully facilitates the start-up. Moreover, aging or degradation of the battery due to intense drawn energy at the start-up is reduced and delayed. As a result, the object of extending life of the start-up battery and the vehicle electronic device is achieved. Moreover, by establishing a parallel connection between the rapid energy storage module and the battery during a normal operation of the system, the voltage of the start-up battery can also remain stable to achieve a regulating effect.

Moreover, by means of charging the rapid energy storage module via the battery immediately after parking, since the rapid energy storage module in the invention has been charged to store energy in a normal mode, only a small amount of battery power is needed to make the energy storage module meet a start-up requirement. Moreover, the detection and warning of battery performance can allow the battery to be replaced until a true minimum remaining power state that is still sufficient to charge the rapid energy storage module to a bootable voltage is met. Therefore, a purpose of exhausting all possible power of the battery can be truly implemented with confidence, thereby diminishing a resource waste in the prior art that replaces the battery only based on measuring the battery internal resistance and under a situation of not reaching a truly unusable state due to a lack of the parallel connection with a rapid energy storage module. The detailed structure, features, assembly, or usage of the battery power sustainability device provided in the invention are described in detail in later embodiments. However, those having ordinary skill in the art of the invention should understand that, the detailed description and specific embodiments provided to implement the invention are only intended to describe the invention and are not intended to limit the claim scope of the invention.

BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIG. 1 is a block diagram of a battery power sustainability device used with a battery-powered system according to an embodiment of the invention.
FIG. 2 is a flow chart of a method for battery power sustainability according to an embodiment of the invention.
FIG. 3 is a block diagram of a battery power sustainability device used with a battery-powered system according to another embodiment of the invention.
FIG. 4 is a flow chart showing the steps in a start-up mode of a method for battery power sustainability according to an embodiment of the invention.
FIG. 5A is an equivalent circuit diagram of a start-up motor and a start-up battery according to an embodiment of the invention.
FIG. 5B is a timing diagram of a load voltage and a load current of a start-up motor at start-up according to an embodiment of the invention.
FIG. 6 is an equivalent circuit diagram of a start-up motor, a rapid energy storage module, and a start-up battery according to an embodiment of the invention.

DESCRIPTION OF THE EMBODIMENTS

In the following, the constituent components of the battery power sustainability device and efficacies achieved are described with reference to preferred embodiments corresponding to various figures. However, the components, size, and appearance of the battery power sustainability device in each figure are only used to describe the technical features of the invention and are not intended to limit the invention.

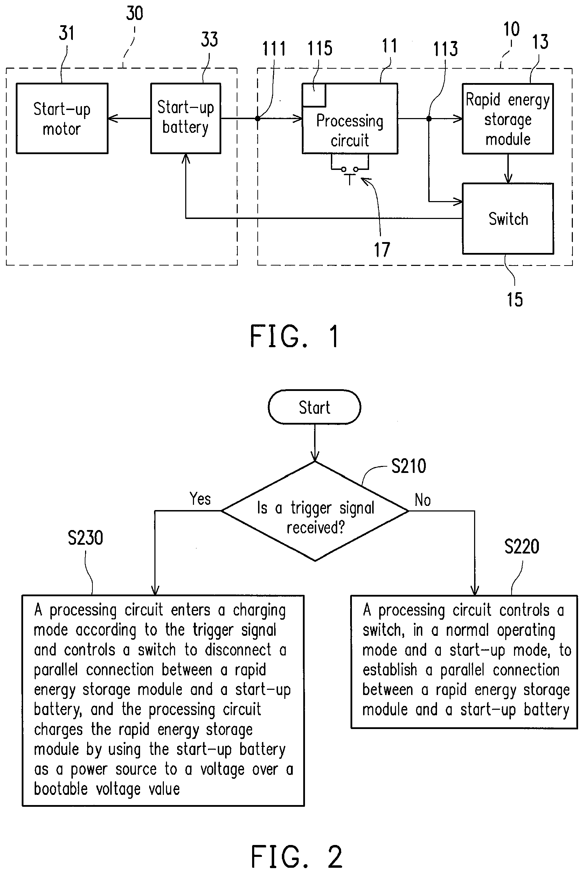

FIG. 1 is a block diagram of a battery power sustainability device according to an embodiment of the present invention used with a battery-powered system. A battery power sustainability device 10 in this embodiment is connected to a battery-powered system 30. In the present embodiment, the battery-powered system 30 is a vehicle start-up system, and the battery power sustainability device 10 is configured to facilitate the power supply of a start-up battery 33. The battery-powered system 30 includes a start-up motor 31 and a start-up battery 33, and the start-up motor 31 is connected to the start-up battery 33. In a normal start-up mode, the start-up motor 31 achieves the object of start-up by means of the power supply from the start-up battery 33 so as to make the engine running. The battery-powered system 30 is a known technique in the industry and thus is no longer described herein.

The battery power sustainability device 10 mainly includes a processing circuit 11 and a switch 15, and can further include a rapid energy storage module 13. An input terminal 111 of the processing circuit 11 is connected to the start-up battery 33 of the battery-powered system 30. The rapid energy storage module 13 is connected to an output terminal 113 of the processing circuit 11. The switch 15 is controlled by the output terminal 113 of the processing circuit 11, and is connected to the rapid energy storage module 13, and the start-up battery 33 of the battery-powered system 30.

The processing circuit 11 disconnects a connection between the rapid energy storage module 13 and the start-up battery 33 via the switch 15 according to a trigger signal and charges the rapid energy storage module 13 to a voltage over a bootable voltage value. In an embodiment of the invention, the processing circuit 11 can be a hardware, firmware, or software stored in a memory and loaded and executed by a microprocessor or digital signal processor, or a machine executable code. In the case of hardware, the processing circuit 11 can be achieved by a single integrated circuit chip, and can also be achieved by a plurality of circuit chips, but the invention is not limited thereto. The plurality of circuit chips or single integrated circuit chip can be implemented by adopting an application-specific integrated circuit (ASIC) or a programmable logic gate array (FPGA). The memory can be, for instance, a random-access memory, a read-only memory, or a flash memory etc.

In an embodiment of the invention, the processing circuit 11 includes a buck-boost module 115 configured to adjust the voltage value of the input terminal 111 and output the voltage to the output terminal 113. In the present embodiment, the buck-boost module 115 is configured to increase the voltage value of the input terminal 111, i.e., to make the voltage value of the output terminal 113 higher than the voltage value of the input terminal 111 to charge the rapid energy storage module 13. Moreover, other charging circuits can also be adopted to charge the rapid energy storage module 13, such as a boost module or other circuits, and therefore the buck-boost module is not the only option.

In an embodiment of the invention, the rapid energy storage module 13 is a supercapacitor, and the charge and discharge speed of the supercapacitor is greater than that of the start-up battery 33 and the life thereof is also longer than that of the start-up battery 33, and therefore the supercapacitor can accumulate the voltage needed for the start-up in a short time. However, the rapid energy storage module 13 is not limited to a supercapacitor.

In the present embodiment, the trigger signal is provided by a trigger switch 17, the trigger switch 17 is connected to the processing circuit 11, the trigger signal is generated and provided to the processing circuit 11 when the trigger switch 17 is turned on. The processing circuit 11 commands the switch 15 to disconnect the connection between the start-up battery 33 and the rapid energy storage module 13 according to the trigger signal, and then charges the rapid energy storage module 13. However, in practice, the trigger signal can also be provided to the processing circuit 11 via other trigger circuits or in other forms, and therefore the generation and provision of the trigger signal are not limited to those in the present embodiment.

In the present embodiment, the switch 15 can be a relay, a transistor, or formed by an electronic circuit, and therefore the switch 15 is not limited to a single switch element.

The processing circuit 11 can also be configured to detect the performance state of the start-up battery 33 and correspondingly generate a notification (or a warning message). The performance state of the start-up battery 33 includes, for instance, output voltage, battery internal resistance, and battery life percentage. The generated notification can be implemented via, for instance, a display, light, or loudspeaker. The display can display the performance state of the start-up battery 33, and the light can reveal the performance state of the start-up battery 33 via different visible light colors. The different visible light colors can comprise, for instance, red, yellow, and green.

The composition of the battery power sustainability device according to one embodiment of the invention is described above. Next, the operation and efficacies of the battery power sustainability device according to the embodiment of the invention are described in detail.

Referring further to FIG. 1, when the battery-powered system 30 can be started normally, it means the voltage value of the start-up battery 33 is sufficient to operate the start-up motor 31 of the battery-powered system 30. Therefore, in a normal start-up, the switch 15 is turned on according to a start-up signal of the battery-powered system 30 to establish an electrical parallel connection between the start-up battery 33 and the rapid energy storage module 13. In particular, the start-up signal can be directly provided by the battery-powered system 30 or be provided to the processing circuit 11 by the battery-powered system 30 and then provided to the switch 15 by the processing circuit 11. The start-up signal is generated by a start-up switch (not shown in figures) of the battery-powered system 30 known in the industry, and is therefore not necessary to described more herein.

The turned-on switch 15 establishes a parallel connection between the start-up battery 33 and the rapid energy storage module 13, and the parallel connection makes the voltage value of the rapid energy storage module 13 roughly the same as the voltage value of the start-up battery 33. At this point, the processing circuit 11 does not charge the rapid energy storage module 13. Therefore, the battery power sustainability device 10 of the invention can enter a regulating mode due to a regulating effect of the rapid energy storage module 13 and effectively increase the stability and lifetime of vehicle electronic products and extend the lifetime of the vehicle ignition system.

In particular, the rapid energy storage module 13 has a faster charge and discharge capacity than the start-up battery 33, and therefore, the rapid energy storage module 13 can be rapidly accumulated to a higher voltage value.

When the voltage of the start-up battery 33 is too low, that phenomenon is also referred to as undervoltage, indicating the battery-powered system 30 cannot be started normally, and therefore a charging mode of the battery power sustainability device 10 can facilitate the start-up of the battery-powered system 30.

Referring further to FIG. 1, in the charging mode, the processing circuit 11 disconnects the electrical connection between the start-up battery 33 and the rapid energy storage module 13 by means of the switch 15 according to the trigger signal and charges the rapid energy storage module 13 using the remaining power of the start-up battery 33 to allow the rapid energy storage module 13 to be accumulated to a higher voltage value. As a result, an instant huge current required in the battery-powered system 30 at start-up stage can be preferentially obtained from the rapid energy storage module 13, and therefore the start-up battery 33 does not lose life prematurely due to rapid extraction of large current.

The operation of the charging mode includes making the processing circuit 11 enter the charging mode via the trigger switch 17, and then the processing circuit 11 controls the switch 15 to form an open state according to the trigger signal. The open state indicates a parallel connection is not established between the start-up battery 33 and the rapid energy storage module 13. As a result, the rapid energy storage module 13 can be charged by the start-up battery 33 via the boost-buck module 115 of the processing circuit 11, and the voltage thereof is increase to a voltage that can start a vehicle. Next, the processing circuit 11 controls the switch 15 to form a conducting state according to the start-up signal, and the conducting state indicates a parallel connection is established between the start-up battery 33 and the rapid energy storage module 13. As a result, the switch 15 being conducted forms a path for the rapid energy storage module 13 to provide an instant large current to the battery-powered system 30 to start the vehicle. Lastly, after the start-up of the battery-powered system 30, the battery power sustainability device 10 of the invention enters the regulating mode.

Since the switch 15 is turned on or in conducting, a parallel connection is established between the start-up battery 33 and the rapid energy storage module 13, and therefore when the battery-powered system 30 is started up, the battery-powered system 30 can be started up by the high voltage of the rapid energy storage module 13 to achieve the object of start-up.

For instance, a rated voltage value of the start-up battery 33 is 12.6 V normally, indicating the battery-powered system 30 can be started normally. If the voltage of the start-up battery 33 is only 11V or less, the power of instant discharge of the start-up battery 33 is insufficient. The start-up battery 33 cannot provide sufficient starting current to the start-up motor 31. In contrast, after the rapid energy storage module 13 is charged, the battery power sustainability device 10 of the invention increases the start-up voltage to 14 V, which can be a start-up power for the start-up motor 31 or an auxiliary power for the start-up battery 33.

In an embodiment, when a vehicle is in normal operation, the start-up battery 33 and the rapid energy storage module 13 are also connected in parallel, and the start-up battery 33 is charged. As a result, the voltage of the start-up battery 33 should remain at about 14 V, and at this point, the voltage of the rapid energy storage module 13 can also remain at about 14 V, and therefore the object of stabilizing the start-up battery 33 voltage can be achieved.

As described above, the generation and provision of the trigger signal are not limited to the present embodiment. Moreover, the above descriptions about the operation reveal that the main technical concepts of the invention resides in that the start-up battery 33 and the rapid energy storage module 13 are disconnected due to a trigger signal to make the rapid energy storage module 13 be charged, and are kept at parallel connection in the start-up and in a normal running after successful start-up to achieve an auxiliary start-up and a function of a regulating mode. Therefore, in addition to providing the trigger signal to the processing circuit 11 by means of pressing the trigger switch 17 to make the processing circuit 11 enter a charging mode when a start-up failure of the battery-powered system 30 is happened, the processing circuit 11, in an alternative embodiment, can also enter the charging mode automatically by means of receiving a start-up fail signal to serve as the trigger signal when a start-up fail of the battery-powered system 30 is happened, without a need to press the trigger switch 17.

Moreover, in the above description, the rapid energy storage module 13 is charged when the battery-powered system 30 does not operate normally after the start-up of the battery-powered system 30,. However, the invention is not limited to such a situation. In another modified example of the invention, the battery power sustainability device 10 can also automatically enter the charging mode when the vehicle is turned off after a drive is finished. As a result, when the vehicle is not being driven, the processing circuit 11 can generate a trigger signal according to an operation stop signal of the battery-powered system 30, and thereby the parallel connection between the rapid energy storage module 13 and the start-up battery 33 is automatically disconnected and the rapid energy storage module 13 is charged by the start-up battery 33 when the battery-powered system 30 is stopped for running. By means of that, when the vehicle is to be started, a parallel connection can be established due to the start-up signal and more sufficient power can be rapidly provided to facilitate the start-up function of the start-up battery 33 so as to ensure a successful start-up of the vehicle.

Moreover, although in the above the rapid energy storage module 13 still maintains a parallel connection with the start-up battery 33 in a normal operation after start-up so as to achieve a regulating effect, in a modified example the parallel connection can be cut off in the normal operation while the rapid energy storage module 13 is charged after the normal operation is stopped. This will not affect the effect of the invention. Moreover, in another modified example, the rapid energy storage module 13 can be not charged first after the operation is stopped, and instead is charged by the start-up battery 33 when the power state of the rapid energy storage module 13 meets a required charging condition. This is especially workable when a parallel connection is established between the battery and the rapid energy storage module in the normal operation, and can also achieve the objects and effect of the invention. Moreover, although in the embodiments above, the start-up battery 33 of the vehicle is exemplified as a target for start-up auxiliary, the battery power sustainability device fort the battery-powered system according to the invention is not limited to cooperate with the start-up battery of a vehicle. The battery power sustainability device can also be applied in various possible devices that each is provided with a start-up battery and requires a greater power to start the motor, such as a wireless vacuum cleaner or a diesel generator, or a battery-powered system that is powered by a battery but requiring a large current instantly. Therefore, the start-up is only a representative word, and in actuality it includes any state and system requiring a greater current. The so-called start-up battery thus contains a battery not for start-up purpose.

Referring to both of FIG. 1 and FIG. 2, FIG. 2 is a flow chart of a method for battery power sustainability according to an embodiment of the invention which is applicable for the battery power sustainability device 10 shown in FIG. 1, but is not limited thereto. First, in step S210, whether a trigger signal is received can be determined by the processing circuit 11. If the result of step S210 is no, it means the processing circuit 11 did not receive the trigger signal, and therefore the processing circuit 11 execute the parallel connection step shown in step S220. In step S220, the processing circuit 11 control the switch 15, in a normal operating mode and a start-up mode, to establish a parallel connection between the rapid energy storage module 13 and the start-up battery 33. On the other hand, if the result of step S210 is yes, it means the processing circuit 11 received the trigger signal, and therefore the processing circuit 11 executes the charging step shown in step S230. In step S230, i.e., entering the charging mode according to the trigger signal, the processing circuit 11 controls the switch 15 to disconnect the parallel connection between the rapid energy storage module 13 and the start-up battery 33 and the processing circuit 11 charges the rapid energy storage module 13 by using the start-up battery 33 as a power source to a voltage over a bootable voltage value. Moreover, the parallel connection step (i.e., step S220) and the charging step (i.e., step S230) are switched in response to various operating modes. Moreover, regarding the other details of the method for battery power sustainability, it is believed that the relevant description of FIG. 1 can provide sufficient teaching, suggestion, and implementing description, and are therefore not described more herein.

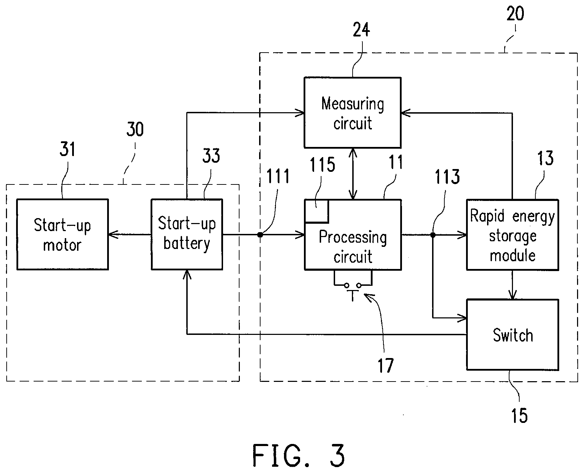

In the above, the processing circuit 11 can be further configured to detect the performance state of the start-up battery 33 and correspondingly generate a notification (or a warning message). In the following, the battery performance detection method is further described with a specific embodiment. In another embodiment of the invention, the battery power sustainability device further has battery state detection function to ensure the user can replace the start-up battery 33 before the start-up battery 33 completely exhausts power. Referring to FIG. 3, FIG. 3 is a block diagram of a battery power sustainability device used with a battery-powered system according to another embodiment of the invention. The battery power sustainability device 20 is connected to the battery-powered system 30, wherein the battery-powered system 30 in FIG. 3 is similar to the battery-powered system 30 of FIG. 1, and therefore its relevant description is as provided for FIG. 1 and is not repeated herein.

Similar to the battery power sustainability device 10 of FIG. 1, the battery power sustainability device 20 of FIG. 3 also include the processing circuit 11, the switch 15, and the rapid energy storage module 13, wherein the processing circuit 11, the switch 15, and the rapid energy storage module 13 of FIG. 3 can be referred to relevant description of FIG. 1 and thus are not described more herein. In comparison to the battery power sustainability device 10 of FIG. 1, the battery power sustainability device 20 of FIG. 3 further includes a measuring circuit 24, but is not limited thereto. In an alternative embodiment of the invention, the measuring circuit can also be integrated in the processing circuit 11.

The measuring circuit 24 is coupled to the rapid energy storage module 13, the start-up battery 33, and the processing circuit 11. The measuring circuit 24 be configured to measure an open voltage of the start-up battery 33 and an internal resistance of the start-up battery 33. Moreover, the measuring circuit 24 can also be used to measure a load or so-called drawn voltage (including peak value and average value), a load or so-called drawn current (including peak value and average value), and a start-up time interval of the start-up motor 31, i.e., load at a start-up stage, and can also measure, for instance, a drawn current or a drawn voltage of the start-up battery 33 only or the rapid energy storage module 13 only at the start-up stage and calculate a consumed start-up power according to, for instance, the measured drawn current, voltage, and start-up time. Moreover, the measuring circuit 24 can also be configured to measure, for instance, a charged voltage of the rapid energy storage module. The measuring circuit 24 can be implemented by adopting a voltage measuring circuit, a current measuring circuit, and a resistance measuring circuit known in the industry, and is therefore not described more herein.

According to the viewpoint of the invention, an estimation of the start-up battery performance is mainly performed under an architecture of the battery power sustainability device disclosed in the invention. According to the viewpoint of one embodiment, a start-up power which is provided by at least one of the rapid energy storage module 13 and the start-up battery 33 to start up the start-up motor 31 can be measured first. Therefore, the processing circuit 11 can estimate the start-up power of the start-up motor 31 and the output power provided by the start-up battery 33 according to the above information measured by the measuring circuit 24, such as the open voltage of the start-up battery 33, the internal resistance value of the start-up battery 33, the load voltage, load current, and start-up time interval of the start-up motor 31 at the start-up stage, and the drawn current and drawn voltage of the start-up battery.. Moreover, the processing circuit 11 can determine the performance state of the start-up battery 33 according to the ratio of the output or drawn power of the start-up battery 33 and the start-up power of the start-up motor 31, or according to a result of whether the ratio of the output power of the start-up battery 33 alone at different start-ups is less than a designated value.

In an example in which the start-up power and the output power of the battery 33 are used to determine the performance state of the start-up battery 33, it should be understood that, the performance of the start-up battery 33 is gradually reduced along with the charge and discharge cycles of the start-up battery 33, and thus the output power that can be provided thereby is gradually reduced. According to the viewpoint of the invention, since a parallel connection is always established between the rapid energy storage module 13 and the start-up battery 33 at the start-up stage, the output or drawn power that needs to be provided by the rapid energy storage module 13 is inevitably gradually increased under this architecture in case the start-up power of the start-up motor 31 does not change. Therefore, by calculating the proportion of the output power of the start-up battery 33 to the start-up power of the start-up motor 31, the performance state of the start-up battery 33 can be more accurately estimated. The detailed description is as follows.

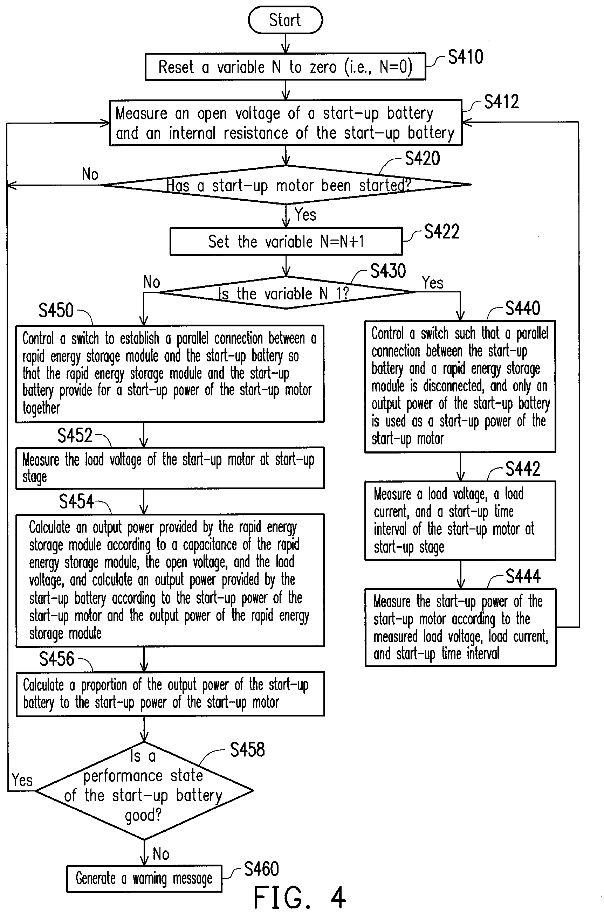

Referring to both FIG. 3 and FIG. 4, FIG. 4 is a flowchart of a start-up mode and a measuring start-up mode of a method for battery power sustainability according to an embodiment of the invention that can be applied in the battery power sustainability device 20 shown in FIG. 3, being not limited thereto, to detect the performance state of the start-up battery 33. First, in step S410, when the start-up battery 33 in the battery-power system 30 is replaced, or the battery power sustainability device 20 is used first time, the processing circuit 11 resets a variable N to zero. Next, in step S412, the open voltage of the start-up battery 33 and the internal resistance of the start-up battery 33 can be measured by the measuring circuit 24. Next, in step S420, the processing circuit 11 determines whether the start-up motor 31 has been started according to a start-up signal. If the result of step S420 is no, it means that the start-up motor 31 is not started, and step S412 is repeated. If the result of step S420 is yes, it means that the start-up motor 31 has been started successfully, and the processing circuit 11 increases the variable N into N+1, as shown in step S422.

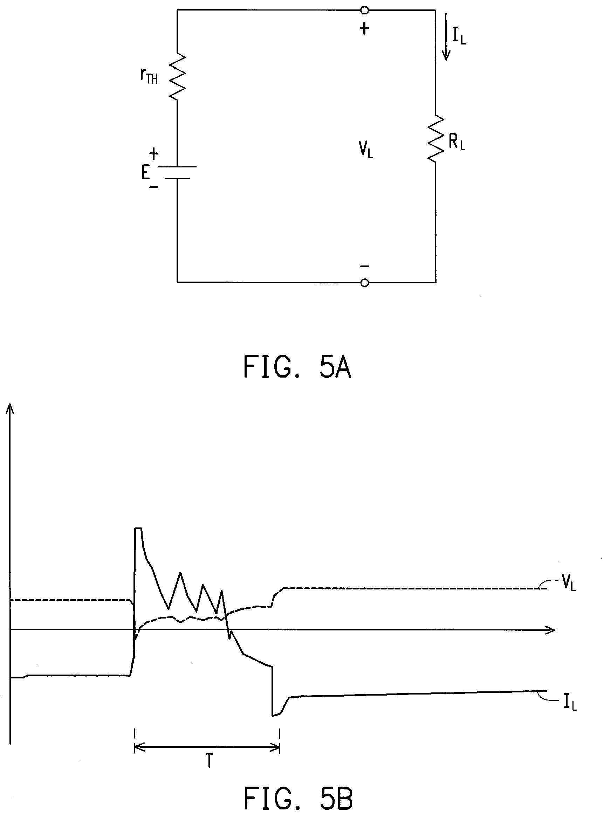

Next, in step S430, the processing circuit 11 determines whether the variable N is 1. If the variable N is 1, it means that the start-up battery 33 provides power to the start-up motor 31 for the first time, and the battery power sustainability device 20 enters into a measuring start-up mode. In this mode, the processing circuit 11 controls the switch 15 such that the parallel connection between the start-up battery 33 and the rapid energy storage module 13 is disconnected, and only the output power of the start-up battery 33 is used as the start-up power of the start-up motor 31 as shown in step S440. In other words, when the start-up motor 33 provides power to the start-up motor 31 for the first time, the start-up power of the start-up motor 31 is provided by the start-up battery 33 only, and the equivalent circuit thereof is shown in FIG. 5A, wherein E represents the open voltage of the start-up battery 33, $r_{TH}$ represents the internal resistance of the start-up battery 33, $V_L$ represents the voltage, i.e., load voltage of the start-up motor 31, $I_L$ represents the current, i.e., load current of the start-up motor 31, and $R_L$ represents an impedance value of the start-up motor 31. The start-up power obtained at this point is in a measuring start-up mode, and is therefore provided by the start-up battery only. Of course, in a modified example, the start-up power may be provided by the rapid energy storage module only, or the start-up power may be provided by both the start-up battery and the rapid energy storage module. In summary, as described above, at least one of the rapid energy storage module 13 and the start-up battery 33 can be used to provide the start-up power needed by the start-up motor 31.

Next, in step S442, a load voltage $V_L(t)$, a load current $I_L(t)$, and a start-up time interval T of the start-up motor 31 at start-up stage can be measured by the measuring circuit 24, wherein the load voltage $V_L(t)$ and the load current $I_L(t)$ are variables changing with time. Next, in step S444, the start-up power $J_L$ of the start-up motor 31 can be calculated by the processing circuit 11 according to the measured load voltage $V_L(t)$, load current $I_L(t)$, and start-up time interval, T as shown in formula (1), wherein the operator * of formula (1) represents a convolution. After step S444 is ended, the processing circuit 11 obtains the start-up power of the start-up motor 31, and step S412 is repeated.

$$J_L = V_L(t) * I_L(t) * T \qquad \text{formula (1)}$$

In an embodiment of the invention, the measuring circuit 24 can detect the start-up time interval of the start-up motor 31 according to the load voltage or load current of the start-up motor 31. Referring to both FIG. 5A and FIG. 5B, FIG. 5B is a timing diagram of a load voltage $V_L$ and a load current $I_L$ of the start-up motor 31 at start-up stage according to an embodiment of the invention, wherein the horizontal axis represents time and the vertical axis represents voltage value or current value. As described above, the start-up motor 31 requires an instant huge current, i.e., the load current $I_L$, to be started, and therefore the measuring circuit 24 can estimate the start-up time interval T of the start-up motor 31 according to the value of the measured load current $I_L$, as shown in FIG. 5B. Moreover, when the start-up motor 31 is started, the load current $I_L$ results in a drop-out voltage at two ends of an internal resistor, having a resistance of $r_{TH}$, of the start-up battery 33 in passing through the internal resistor. The load voltage $V_L$ is thus reduced. Therefore, the measuring circuit 24 can also estimate the start-up time interval T of the start-up motor 31 according to the value of the load voltage $V_L$, as shown in FIG. 5B.

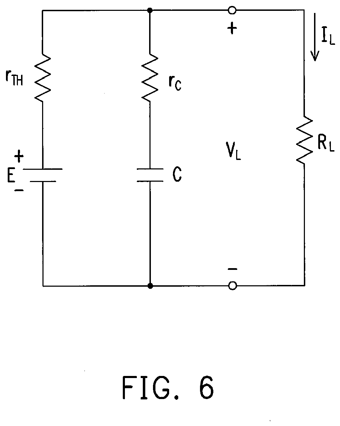

Referring to both FIG. 3 and FIG. 4 again, in step S430, if the variable N is not 1, it means that the battery power sustainability device 20 is operated in the start-up mode and the start-up battery 33 is not a first time to provide power to the start-up motor 31. At this point, the processing circuit 11 control the switch 15 to establish a parallel connection between the rapid energy storage module 13 and the start-up battery 33 so that the rapid energy storage module 13 and the start-up battery 33 provide for the start-up power of the start-up motor 31 together, as shown in step S450. In other words, when the start-up battery 33 is not a first time to provide power to the start-up motor 31, the start-up power of the start-up motor 31 is provided by the start-up battery 33 and the rapid energy storage module 13 together, and the equivalent circuit thereof is shown in FIG. 6, wherein E represents the open voltage of the start-up battery 33, $r_{TH}$ represents the internal resistance of the start-up battery 33, C represents a capacitance value of the rapid energy storage module 13, $r_C$ represents a resistance value, being negligible, of the rapid energy storage module 13, $V_L$ represents the voltage (i.e., load voltage) of the start-up motor 31, $I_L$ represents the current (i.e., load current) of the start-up motor 31, and $R_L$ represents the impedance value of the start-up motor 31. In particular, as described in a modified example above, the start-up power can also be measured in the start-up mode. That is, when N=2, the common start-up output of the start-up battery 33 and the rapid energy storage module 13 is measured as the start-up power mentioned above and as one of the bases for the evaluation of start-up battery performance.

Next, in step S452, the load voltage of the start-up motor 31 at start-up stage is measured by the measuring circuit 24. Next, in step S454, the processing circuit 11 calculates an output power, i.e., loaded power, Jc provided by the rapid energy storage module 13 according to the capacitance C of the rapid energy storage module 13, the open voltage E, and the load voltage $V_L$, as shown in formula (2). The processing circuit 11 can also calculate an output power, i.e., loaded power, $J_E$ provided by the start-up battery 33 according to the start-up power $J_L$ of formula (1) and the output power Jc of the rapid energy storage module 13 shown in formula (2), as shown in formula (3).

$$J_C = \frac{1}{2}C(E^2 - V_L^2) \qquad \text{formula (2)}$$

$$J_E = J_L - J_C = J_L - \frac{1}{2}C(E^2 - V_L^2) \qquad \text{formula (3)}$$

Next, in step S456, the processing circuit 11 calculates the proportion of the output power $J_E$ of the start-up battery 33 to the start-up power $J_L$ of the start-up motor 31. Next, in step S458, the processing circuit 11 determines whether the performance state of the start-up battery 33 is good according to the proportion. If the result of step S458 is good, then step S412 is repeated for the next performance detection operation of the start-up battery 33 when the start-up motor 31 is started next time. If the result of step S458 is abnormal, then the processing circuit 11 generates a warning message, as shown in step S460.

In an embodiment of the invention, in step S458, when the proportion of the output power $J_E$ to the start-up power $J_L$ is less than a first threshold value, the processing circuit 11 can determine the performance state of the start-up battery 33 is abnormal and generate a warning message in step S460. In an embodiment of the invention, the processing circuit 11 can send and display the warning message on a display, but the invention is not limited thereto. In other embodiments of the invention, the processing circuit 11 can also warn the user via a light or a loudspeaker.

In an embodiment of the invention, the processing circuit 11 can also generate different warning messages according to different proportions of the output power $J_E$ to the start-up power $J_L$. For instance, when the proportion of the output power $J_E$ to the start-up power $J_L$ is less than a first threshold value but greater than a second threshold value, the processing circuit 11 issue a warning message indicating an insufficient start-up capacity of the start-up battery 33 or a dying battery life, wherein the first threshold value is greater than the second threshold value. Moreover, when the proportion of the output power $J_E$ to the start-up power $J_L$ is less than the second threshold value, the processing circuit 11 issue a warning message indicating a seriously insufficient start-up capacity of the start-up battery 33 or a need to change the battery immediately. The first threshold value and the second threshold value can be set according to an actual application or design requirement.

In an embodiment of the invention, the processing circuit 11 can also display remaining times that the start-up battery 33 can start the start-up motor 31 on the display according to the proportion of the output power $J_E$ to the start-up power $J_L$ so as to provide a reference basis to remind the user to replace the start-up battery 33.

In an embodiment of the invention, the processing circuit 11 can also determine the performance state of the start-up battery 33 according to both the measured internal resistance $r_{TH}$ of the start-up battery 33 and the proportion of the output power $J_E$ to the start-up power $J_L$. For instance, when the proportion is less than the first threshold value and the internal resistance $r_{TH}$ is greater than a reference resistance, the processing circuit 11 can determine that the performance state of the start-up battery 33 is abnormal and generates a warning message.

Since in the invention, the performance state of the start-up battery 33 is detected when the start-up motor 31 is started, the performance state of the start-up battery 33 detected by the processing circuit 11 reflects an actual performance state of the start-up battery 33 at a moment of doing discharge to the start-up motor 31 at the start-up stage. Therefore, in comparison to a way to detect the performance state of a battery detected by a conventional handheld battery analyzer which conducts a detection based upon a short time and a small current discharge, the operation provided by the invention to detect the performance state of the start-up battery 33 can more accurately detect the performance state of the start-up battery 33 in actual operation and can ensure that the user can replace the start-up battery 33 at an appropriate timing before the start-up battery 33 completely exhausts power.

Moreover, in the embodiments above, the warning related to the performance of the start-up battery 33 is determined based upon the ratio of the output power $J_E$ of the start-up battery to the total start-up power JL being less than a predetermined value that indicates a low drawn power condition, and the output power of the start-up battery 33 can be directly measured, or be extrapolated secondarily by measuring the output power of the rapid energy storage module 13 first. However, in another modified example, the warning of the battery performance can also be obtained by comparing other data. For instance, the low drawn power condition, as a basis for determination, can be one situation that the ratio of the drawn power of the battery 33 to the drawn power of the rapid energy storage module 13 is less than a designated value, or one that the ratio of the drawn power of the battery 33 measured in a first use with the battery power sustainability device of the invention to the drawn power of the battery 33 measured in a most recent use with the battery power sustainability device is less than a designated value. Alternatively, the warning message can also be issued once the start-up battery 33 meets a predetermined low drawn power condition. The measurement of the low drawn power is same to the above description, and the only difference is the data to be compared. Therefore, the details of that are not repeated herein.

Moreover, as described above, the determination on whether a warning should be issued for the remaining power of the start-up battery can also be done solely based on whether a charged voltage of the rapid energy storage module reaches a designated bootable voltage value. Moreover, according to another viewpoint of the present embodiment, the performance of the start-up battery can also be determined directly based upon the drawn current value of the start-up battery being less than a designated value. Therefore, in summary, by means of the parallel connection between the rapid energy storage module and the start-up battery according to this invention and the measurement of the electrical drawn property of the start-up battery, the start-up battery possibly achieves 2 to 4 times the original service life or longer, and the user can be notified to replace the start-up battery in a timely manner before exhaustion.

## Claims

**1.** A battery power sustainability device (10, 20), comprising:

a switch device (15) controlling a connection between a rapid energy storage module (13) and a battery (33); and a processing circuit (11) configured to control a status of the switch device (15) in response to a plurality of operating modes, comprising controlling the switch device (15) to establish a parallel connection between the rapid energy storage module (13) and the battery (33) in a start-up mode in which a battery-powered system (30) is starting; and controlling the switch device (15) to disconnect the parallel connection between the rapid energy storage module (13) and the battery (33) in a charging mode started by receiving a trigger signal, wherein the trigger signal is generated according to an operation stop signal of the battery-powered system (30).

**2.** The battery power sustainability device (10, 20) of claim 1, wherein in the charging mode, the processing circuit (11) charges the rapid energy storage module (13) by using the battery (33) as a power source to a voltage over a bootable voltage value.

**3.** The battery power sustainability device of claim 2 (10, 20), wherein in the charging mode, the processing circuit (11) charges the rapid energy storage module (13) by using the battery (33) as the power source to a voltage over the bootable voltage value only when the voltage of the rapid energy storage module (13) is less than a designated value.

**4.** The battery power sustainability device (10, 20) according to any one of the claims 2-3, wherein the processing circuit (11) comprises a buck-boost module (115), and the bootable voltage value is greater than a residual voltage of the battery (33).

**5.** The battery power sustainability device (10, 20) according to any one of the preceding claims, further comprising the rapid energy storage module (13), and the processing circuit (11) also controls the switch device (15) to establish a parallel connection between the rapid energy storage module (13) and the battery (33) in a normal operating mode in which the battery-powered system (30) is running.

**6.** The battery power sustainability device (10, 20) according to any one of the preceding claims, wherein the operation stop signal is a start failure signal of the battery-powered system (30).

**7.** The battery power sustainability device (20) according to any one of the preceding claims, further comprising a measuring circuit (24) configured to detect an electrical drawn property of the battery (33) when the battery-powered system (30) is at a start-up stage so as to determine a performance state of the battery (33); and a warning device configured to generate a warning when the battery (33) meets a low drawn power condition.

**8.** The battery power sustainability device (20) of claim 7, wherein:
the measuring circuit (24) is configured to measure a start-up drawn power ($J_L$) of at least one of the battery (33) and the rapid energy storage module (13) when the battery-powered system (30) is at the start-up stage and configured to detect a drawn power ($J_E$) of the battery (33) in the start-up mode of the battery power sustainability device (20); and the low drawn power condition indicates that a ratio of the drawn power ($J_E$) of the battery (33) in the start-up mode to the start-up drawn power ($J_L$) is less than a designated value.

**9.** The battery power sustainability device (20) of claim 8, wherein:
the measuring circuit (24) calculates an drawn power ($J_C$) provided by the rapid energy storage module (13) according to a capacitance value (C) of the rapid energy storage module (13), an open voltage (E) of the battery (33) and a load voltage ($V_L$) of a load (31), and calculates the drawn power ($J_E$) of the battery (33) according to the start-up drawn power ($J_L$) and the drawn power ($J_C$) of the rapid energy storage module (13).

**10.** The battery power sustainability device (20) of claim 7, wherein:
the measuring circuit (24) is further configured to detect a drawn power ($J_E$) of the battery (33) and a drawn power ($J_C$) of the rapid energy storage module (13) in the start-up mode of the battery power sustainability device (20); and the low drawn power condition indicates that a ratio of the drawn power ($J_E$) of the battery (33) to the drawn power ($J_C$) of the rapid energy storage module (13) is less than a designated value, or a ratio of the drawn power ($J_E$) of the battery (33) used with the rapid energy storage module (13) first time and the drawn power ($J_E$) of the battery (33) in a most recent use with the rapid energy storage module (13) last time is less than a designated value.

**11.** The battery power sustainability device (20) of claim 7, wherein the electrical drawn property of the battery (33) refers to a drawn current, and the low drawn power condition refers to a designated current value of the drawn current, or refers to a ratio of the current value of the battery (33) used with the rapid energy storage module (13) first time and the current value of the battery (33) in a most recent use with the rapid energy storage module (13).

**12.** The battery power sustainability device (10) according to any one of the claims 2-6, wherein the processing circuit (11) further comprises a measuring circuit configured to detect a voltage of the rapid energy storage module (13); and a warning device configured to issue a warning when the rapid energy storage module (13) cannot be charged to a designated voltage.

**13.** A method for battery power sustainability, comprising:

a parallel connection step (S220) configured to control a switch device (15) to establish a parallel connection between a rapid energy storage module (13) and a battery (33) via a processing circuit (11) in a start-up mode in which a battery-powered system (30) is starting; and

a charging step (S230) configured to control the switch device (15) to disconnect the parallel connection between the rapid energy storage module (13) and the battery (33) via the processing circuit (11) in a charging mode started by receiving a trigger signal;

wherein the trigger signal is generated according to an operation stop signal of the battery-powered system (30).

**14.** The method for the battery power sustainability of claim 13, wherein the charging step (S230) further comprises a step of charging the rapid energy storage module (13) by using the battery (33) as a power source to a voltage over a bootable voltage value, and charging the rapid energy storage module (13) only when the voltage of the rapid energy storage module (13) is less than a designated value.

**15.** The method for the battery power sustainability according to any one of the claims 13-14, further comprising:

detecting a start-up power ($J_L$) provided by at least one of the rapid energy storage module (13) and the battery (33) to start up a load (31);

estimating an output power ($J_E$) provided by the battery (33) in the start-up mode; and

determining a performance state of the battery (33) according to a proportion between the output power ($J_E$) of the battery (33) and the start-up power ($J_L$) and providing a warning message when the proportion is less than a first threshold value.

**16.** The method for the battery power sustainability of claim 15, wherein the step of detecting the start-up power ($J_L$) comprises:

controlling the switch device (15) to disconnect the parallel connection between the battery (33) and the rapid energy storage module (13) and use the output power ($J_E$) of the battery (33) as the start-up power ($J_L$) in an measuring start-up mode in which the processing circuit (11) is initially used with the battery (33) ; and

detecting a load voltage ($V_L$), a load current ($I_L$), and a start-up time interval (T) of the load (31) to accordingly calculate the start-up power ($J_L$).

**17.** The method for the battery power sustainability according to any one of the claims 15-16, wherein the step of estimating the output power ($J_E$) of the battery (33) comprises:

detecting an open voltage (E) of the battery (33);

controlling the switch device (15) to establish a parallel connection between the rapid energy storage module (13) and the battery (33) so that the rapid energy storage module (13) and the battery (33) provide for the start-up power ($J_L$) together in the start-up mode;

detecting a load voltage ($V_L$) of the load (31) when the load (31) is at a start-up stage;

calculating an output power ($J_C$) provided by the rapid energy storage module (13) according to a capacitance value (C) of the rapid energy storage module (13), the open voltage (E), and the load voltage ($V_L$); and

calculating the output power ($J_E$) of the battery (33) according to the start-up power ($J_L$) and the output power ($J_C$) of the rapid energy storage module (13).

**18.** The method for the battery power sustainability according to any one of the claims 14-17, further comprising a step of detecting a voltage of the rapid energy storage module (13) and a warning step of issuing a warning when the rapid energy storage module (13) cannot be charged to a designated voltage.

**19.** The method for the battery power sustainability according to any one of the claims 13-14, further comprising a detecting step of detecting a drawn current of the battery (33) in each start-up; and a warning step of issuing a warning when the drawn current is less than a designated current value or a ratio of the drawn current value of the battery (33) used with the rapid energy storage module (13) first time to the drawn current value of the battery (33) in a most recent use with the rapid energy storage module (13) is less than a designated value.

31    30        33        111  115      11      113        10  13

```
┌──────────────────────────────┐   ┌────────────────────────────────────┐
│ ┌──────────┐    ┌──────────┐  │   │  ┌──────────┐      ┌──────────────┐ │
│ │ Start-up │◄───│ Start-up │──┼─●─┼─►│┌─┐       │      │ Rapid energy │ │
│ │  motor   │    │ battery  │  │   │  ││ │Processing│    │   storage    │ │
│ └──────────┘    └──────────┘  │   │  │└─┘ circuit │───●─►│   module    │ │
│                      ▲        │   │  │   ┌─┐    │   │    └──────────────┘ │
│                      │        │   │  └───┤ ├────┘   │           │        │
│                      │        │   │      T └──┐     │           ▼        │
│                      │        │   │           │     │    ┌──────────────┐│
│                      └────────┼───┼───────────┼─────┼───►│    Switch    ││
│                               │   │           │     │    └──────────────┘│
└──────────────────────────────┘   │          17     │           │        │
                                    └────────────────────────────┼────────┘
                                                                 15
```

FIG. 1

```
                    ┌──────────┐
                    │  Start   │
                    └────┬─────┘
                         │
                         ▼          ╱S210
             Yes    ◄─╱            ╲     No
        ┌────────────╱ Is a trigger ╲──────────────┐
  S230  │            ╲   signal     ╱         S220  │
        │             ╲ received?  ╱               │
        │              ╲          ╱                │
        ▼               ╲        ╱                 ▼
```

| S230 | S220 |
|------|------|
| A processing circuit enters a charging mode according to the trigger signal and controls a switch to disconnect a parallel connection between a rapid energy storage module and a start-up battery, and the processing circuit charges the rapid energy storage module by using the start-up battery as a power source to a voltage over a bootable voltage value | A processing circuit controls a switch, in a normal operating mode and a start-up mode, to establish a parallel connection between a rapid energy storage module and a start-up battery |

FIG. 2

FIG. 3

Start

Reset a variable N to zero (i.e., N=0) — S410

Measure an open voltage of a start-up battery and an internal resistance of the start-up battery — S412

S420
Has a start-up motor been started?

No

Yes

Set the variable N=N+1 — S422

S430
Is the variable N 1?

No

Yes

S450
Control a switch to establish a parallel connection between a rapid energy storage module and the start-up battery so that the rapid energy storage module and the start-up battery provide for a start-up power of the start-up motor together

S440
Control a switch such that a parallel connection between the start-up battery and a rapid energy storage module is disconnected, and only an output power of the start-up battery is used as a start-up power of the start-up motor

S452
Measure the load voltage of the start-up motor at start-up stage

S442
Measure a load voltage, a load current, and a start-up time interval of the start-up motor at start-up stage

S454
Calculate an output power provided by the rapid energy storage module according to a capacitance of the rapid energy storage module, the open voltage, and the load voltage, and calculate an output power provided by the start-up battery according to the start-up power of the start-up motor and the output power of the rapid energy storage module

S444
Measure the start-up power of the start-up motor according to the measured load voltage, load current, and start-up time interval

S456
Calculate a proportion of the output power of the start-up battery to the start-up power of the start-up motor

S458
Is a performance state of the start-up battery good?

Yes

No

Generate a warning message — S460

FIG. 4

14

FIG. 5A

FIG. 5B

FIG. 6

Europäisches
Patentamt

European
Patent Office

Office européen
des brevets

**EUROPEAN SEARCH REPORT**

Application Number

EP 18 16 9374

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2015 009654 A (SANYO ELECTRIC CO) 19 January 2015 (2015-01-19) * page 4, paragraph 19 - page 8, paragraph 45; figures 1-3 * | 1-19 | INV. F02N11/08 H02J7/34 H02J1/06 B60R16/033 |
| A | US 2012/235473 A1 (JIANG JUNWEI [US] ET AL) 20 September 2012 (2012-09-20) * page 4, paragraph 46 - paragraph 50; figures 6,7 * | 1-19 | ADD. H02J1/00 |
| A | US 2016/327007 A1 (AVERBUKH MOSHE [IL] ET AL) 10 November 2016 (2016-11-10) * page 1, paragraph 23 - page 3, paragraph 62 * * page 4, paragraph 88 - page 6, paragraph 136; figures 2,3 * * page 6, paragraph 141 - paragraph 142; figure 5 * * page 8, paragraph 170 - paragraph 181; figures 12A,12B * | 1-19 | |
| A | US 2009/322101 A1 (REYNOLDS MICHAEL G [US]) 31 December 2009 (2009-12-31) * page 1, paragraph 7 - page 3, paragraph 28; figure 1 * * page 4, paragraph 37 - page 5, paragraph 52; figure 4 * | 1-19 | TECHNICAL FIELDS SEARCHED (IPC) H02J B60R F02N |
| A | US 2006/201724 A1 (LEBLANC JEAN-FRANCOIS [CA]) 14 September 2006 (2006-09-14) * page 3, paragraph 39 - paragraph 40 * | 1-19 | |

The present search report has been drawn up for all claims

| Place of search | Date of completion of the search | Examiner |
|---|---|---|
| Munich | 29 June 2018 | Mäki-Mantila, Harri |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 16 9374

This annex lists the patent family members relating to the patent documents cited in the above-mentioned European search report.
The members are as contained in the European Patent Office EDP file on
The European Patent Office is in no way liable for these particulars which are merely given for the purpose of information.

29-06-2018

| Patent document cited in search report | | | Publication date | Patent family member(s) | | | Publication date |
|---|---|---|---|---|---|---|---|
| JP 2015009654 | A | | 19-01-2015 | NONE | | | |
| US 2012235473 | A1 | | 20-09-2012 | CN | 103534133 | A | 22-01-2014 |
| | | | | CN | 103534134 | A | 22-01-2014 |
| | | | | CN | 103534135 | A | 22-01-2014 |
| | | | | CN | 103547475 | A | 29-01-2014 |
| | | | | CN | 103687749 | A | 26-03-2014 |
| | | | | EP | 2686195 | A1 | 22-01-2014 |
| | | | | EP | 2686196 | A2 | 22-01-2014 |
| | | | | EP | 2686197 | A2 | 22-01-2014 |
| | | | | EP | 2686198 | A1 | 22-01-2014 |
| | | | | EP | 2686199 | A2 | 22-01-2014 |
| | | | | US | 2012235473 | A1 | 20-09-2012 |
| | | | | US | 2012235511 | A1 | 20-09-2012 |
| | | | | US | 2012235624 | A1 | 20-09-2012 |
| | | | | US | 2012235642 | A1 | 20-09-2012 |
| | | | | US | 2012237799 | A1 | 20-09-2012 |
| | | | | US | 2016176298 | A1 | 23-06-2016 |
| | | | | WO | 2012125954 | A2 | 20-09-2012 |
| | | | | WO | 2012125956 | A1 | 20-09-2012 |
| | | | | WO | 2012125963 | A2 | 20-09-2012 |
| | | | | WO | 2012125968 | A1 | 20-09-2012 |
| | | | | WO | 2012125971 | A2 | 20-09-2012 |
| US 2016327007 | A1 | | 10-11-2016 | NONE | | | |
| US 2009322101 | A1 | | 31-12-2009 | CN | 101614177 | A | 30-12-2009 |
| | | | | DE | 102009029849 | A1 | 04-02-2010 |
| | | | | US | 2009322101 | A1 | 31-12-2009 |
| US 2006201724 | A1 | | 14-09-2006 | CA | 2538646 | A1 | 10-09-2006 |
| | | | | US | 2006201724 | A1 | 14-09-2006 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 103812166